Europäisches Patentamt

European Patent Office

Office européen des brevets

(19)

(11) **EP 0 964 260 A1**

(12) **DEMANDE DE BREVET EUROPEEN**

(43) Date de publication:
**15.12.1999  Bulletin 1999/50**

(51) Int Cl.6: **G01R 33/26**

(21) Numéro de dépôt: **99401366.2**

(22) Date de dépôt: **07.06.1999**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **09.06.1998  FR 9807216**

(71) Demandeur: **COMMISSARIAT A L'ENERGIE ATOMIQUE**
**75752 Paris Cédex 15 (FR)**

(72) Inventeur: **Leger, Jean-Michel**
**38190 Villard Bonnot (FR)**

(74) Mandataire: **Signore, Robert**
**c/o BREVATOME**
**3, rue du Docteur Lanceraux**
**75008 Paris (FR)**

(54) **Dispositif de mesure des composantes d'un champ magnétique à l'aide d'un magnétomètre scalaire**

(57)    Selon l'invention, un magnétomètre scalaire (10, 14, 16, 24, 40, 46, 56) est entouré d'au moins deux enroulements conducteurs (Ex, Ey, Ez) alimentés par des générateurs de fréquences différentes (Gz, Gy, Gz). Par démodulation du signal délivré par le magnétomètre scalaire (Dx, Dy, Dz) on trouve les composantes (Bx, By, Bz) du champ appliqué le long des axes des enroulements.

Application à la mesure des champs faibles.

## Description

### Domaine technique

La présente invention a pour objet un dispositif de mesure des composantes d'un champ magnétique à l'aide d'un magnétomètre scalaire. Elle trouve une application dans la mesure des champs magnétiques faibles (de l'ordre de grandeur du champ magnétique terrestre, soit quelques dizaines de microteslas).

### Etat de la technique antérieure

Depuis de nombreuses années des travaux ont été consacrés à la mesure vectorielle de champs magnétiques à partir de magnétomètres intrinsèquement scalaires (c'est-à-dire sensibles uniquement au module du champ magnétique, indépendamment de sa direction). L'idée sous-jacente de ces travaux est de tirer parti du caractère absolu des mesures scalaires (basées sur la résonance de protons (RMN) ou d'électrons (RPE)) pour pallier l'un des défauts majeurs des capteurs vectoriels, à savoir leur décalage ("offsets") et les dérives basse fréquence associées.

Une telle réalisation est décrite par exemple dans le brevet FR-A-2 663 751 ou dans son correspondant américain US-A-5,221,897. Ces documents contiennent en outre des références bibliographiques sur le sujet.

Cependant, ces réalisations reposent sur l'application séquentielle de champs de polarisation de forte amplitude (généralement largement supérieure au champ magnétique terrestre). Le magnétomètre ne délivre donc pas une mesure continue puisqu'il faut tenir compte, d'une part, du temps d'établissement des champs de polarisation et, d'autre part, du temps de stabilisation de la mesure à partir de laquelle la projection du champ magnétique sur l'axe d'application du champ créé artificiellement est évaluée.

On conçoit, dans ces conditions, qu'aucun filtrage anti-repliement ne soit possible (pour éviter le repliement du spectre lié à l'échantillonnage) et, d'autre part, qu'un tel magnétomètre ne soit pas adapté aux champs rapidement variables, comme cela peut être le cas lors de mesures à bord de satellites : on observe couramment des taux de variation du module du champ de plusieurs dizaines de nT/s et de plusieurs centaines voire milliers de nT/s pour certaines composantes. En outre, pour ces applications, il est souvent demandé que les mesures vectorielles soient faites à une cadence permettant une bande d'analyse d'au moins 10 Hz, voire davantage, au voisinage des pôles (typiquement jusqu'à 25 Hz).

Le but de l'invention est justement de remédier à ces inconvénients.

## Exposé de l'invention

A cette fin, l'invention propose un dispositif de mesure des composantes d'un champ magnétique utilisant un magnétomètre scalaire, caractérisé en ce qu'il comprend :

- au moins deux enroulements conducteurs disposés autour dudit magnétomètre scalaire, ces enroulements conducteurs ayant des axes orientés dans des directions différentes,
- des moyens pour alimenter chaque enroulement par un courant ayant une fréquence déterminée propre à cet enroulement,
- des moyens de traitement recevant le signal de sortie délivré par le magnétomètre scalaire, ces moyens étant aptes à effectuer des démodulations synchrones au moins aux fréquences des courants d'alimentation des enroulements, ces moyens de traitement délivrant, pour chaque fréquence, un signal correspondant à la composante du champ magnétique appliqué selon l'axe de l'enroulement alimenté à cette fréquence.

De préférence, les moyens de traitement sont également aptes à effectuer des démodulations synchrones aux fréquences harmoniques ou à la combinaison linéaire des fréquences des courants d'alimentation des enroulements.

De préférence, les axes des enroulements conducteurs sont mutuellement orthogonaux.

Dans un mode de réalisation avantageux, le dispositif comprend un premier enroulement conducteur avec un premier axe dirigé selon une première direction et un deuxième enroulement conducteur avec un deuxième axe dirigé selon une deuxième direction orthogonale à la première ; les moyens de traitement délivre un premier signal correspondant à une première composante du champ magnétique selon la première composante du champ magnétique selon la première direction et un deuxième signal correspondant à une deuxième composante du champ magnétique selon la deuxième direction ; les moyens de traitement sont en outre aptes à calculer, à partir du signal délivré par le magnétomètre scalaire isotrope correspondant au module du champ magnétique appliqué et à partir desdits premier et deuxième signaux, un troisième signal correspondant à une troisième composante du champ magnétique appliqué selon une troisième direction orthogonale à la première et à la deuxième.

Dans un autre mode de réalisation, on utilise trois enroulements conducteurs à axes mutuellement orthogonaux et le dispositif délivre directement les trois composantes du champ.

Pour répondre aux contraintes de bande passante sur les mesures vectorielles, il faut utiliser un magnétomètre dont la limitation en fréquence d'utilisation soit notablement plus élevée que les bandes passantes requises sur les mesures vectorielles (bande passante utile de plusieurs centaines de Hertz au minimum) et dont la résolution en mesure scalaire soit au moins de deux ordres de grandeur supérieure à la précision requise sur les composantes du champ (une précision de 100 pT sur les mesures vectorielles implique une résolution du capteur scalaire de 1 pT ou mieux).

Pour ces raisons, on utilise de préférence un magnétomètre scalaire à pompage optique à hélium comme celui qui est décrit, par exemple, dans le document FR-A-2 713 347 (ou son correspondant américain US-A-5,534,776).

**Brève description des dessins**

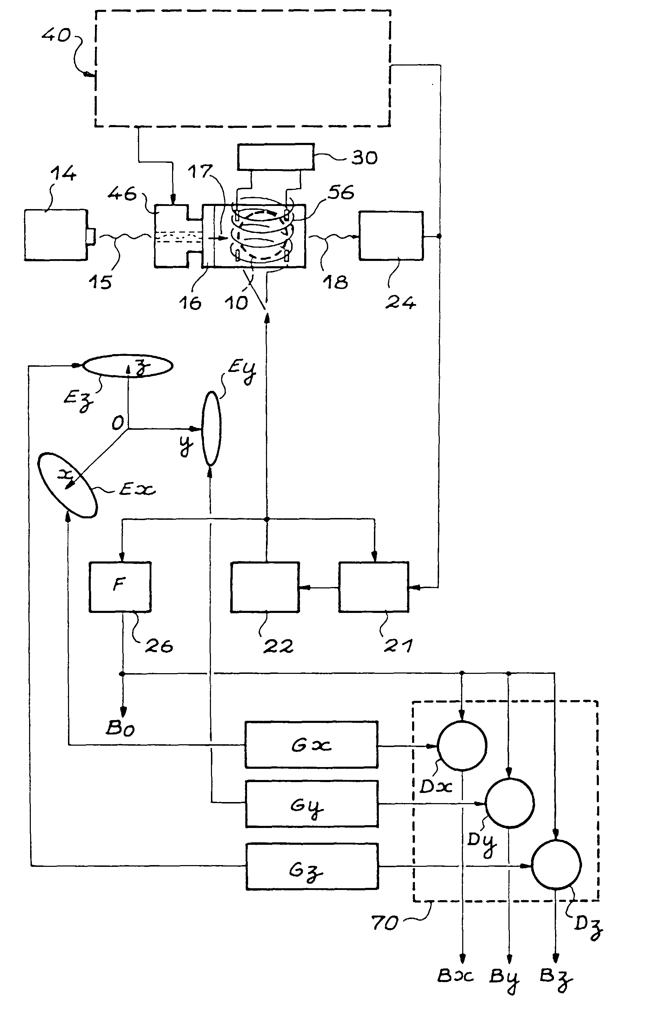

La figure unique annexée illustre un mode de réalisation d'un dispositif conforme à l'invention.

**Description d'un mode particulier de réalisation**

On voit, d'abord, sur la figure unique annexée, un magnétomètre scalaire à pompage optique à hélium conforme au document FR-A-2 713 347 déjà cité (ou son correspondant américain US-A-5,534,776).

Ce magnétomètre comprend une cellule 10 remplie d'hélium, un laser 14 émettant un faisceau 15, un polariseur 16 délivrant un faisceau polarisé rectiligne 17, un photodétecteur 24 recevant le faisceau 18 ayant traversé la cellule, un circuit d'asservissement de fréquence 21, un générateur de radiofréquence 22, un fréquencemètre 26 et un circuit de décharge 30. Le générateur 22 alimente en courant une bobine 56 placée à proximité de la cellule 10 de façon à engendrer dans cette dernière un champ de radiofréquence. La bobine 56 et le polariseur 16 sont solidarisés mécaniquement, de telle façon que toute rotation appliquée au polariseur entraîne une rotation du même angle de la direction du champ, l'intensité de ce dernier étant définie par le générateur 22. Avantageusement, pour relier les moyens 56 et 16, on utilise un contact tournant, par exemple un contact par couplage capacitif ou par un transformateur dont l'enroulement primaire est fixe et l'enroulement secondaire mobile.

De préférence, la bobine et le polariseur sont montés de façon à ce que la polarisation et le champ appliqué soient parallèles.

Le circuit 40 est un circuit d'asservissement qui commande un moteur 46 réglant la position angulaire du polariseur 16. Ce circuit est décrit dans le document cité.

Selon l'invention, et dans le mode de réalisation illustré, le dispositif comprend en outre trois enroulements conducteurs Ex, Ey, Ez dont les axes forment un trièdre trirectangle Oxyz. Pour plus de clarté, ces enroulements sont représentés écartés de la cellule 10 mais, il faut comprendre que ces enroulements entourent la cellule 10. Ces enroulements sont reliés à trois générateurs, respectivement Gx, Gy et Gz, réglés chacun sur une fréquence particulière.

Un circuit de traitement 70 comprend trois démodulateurs Dx, Dy, Dz reliés respectivement aux générateurs Gx, Gy, Gz et recevant le signal de sortie délivré par le magnétomètre scalaire, c'est-à-dire, dans le mode de réalisation illustré, le signal délivré par le fréquencemètre 26. Ce signal est, en général, un signal numérique donnant le module Bo du champ à mesurer.

L'application d'un champ extérieur Hx appliqué le long de l'axe Ox avec une fréquence Fx modifie le module du champ à mesurer d'une quantité qui varie à la fréquence Fx. Le signal de sortie du magnétomètre scalaire, qui donne le module du champ, contient donc une composante variant à la fréquence Fx, composante qui dépend de la projection du champ à mesurer sur l'axe Ox. En démodulant le signal de sortie du magnétomètre scalaire à la fréquence Fx, on accèdera à cette composante. De même pour les deux autres composantes.

Le circuit 70 est classique et peut travailler soit par multiplication et démodulation, soit par transformation de Fourier rapide (FFT). Il délivre les composantes Bx, By, Bz du champ selon les trois directions Ox, Oy, Oz.

Les trois composantes Bx, By, Bz du champ sont reliées au module du champ Bo par la relation

$$B_x^2 + B_y^2 + B_z^2 = B_0^2.$$

On peut donc aussi n'utiliser que deux enroulements, par exemple Ex, Ey, deux générateurs Gx, Gy et deux démodulateurs Dx, Dy pour obtenir les deux composantes Bx et By et retrouver la troisième Bz à partir de la valeur continue Bo donnée par le fréquencemètre 26. La relation donnant Bz est à l'évidence :

$$\left| Bz \right| = \left[ B_0^2 - B_x^2 - B_y^2 \right]^{1/2}$$

Naturellement, le mode de réalisation qui vient d'être décrit n'est donné qu'à titre d'exemple et l'on pourrait utiliser un autre magnétomètre scalaire que le magnétomètre décrit, l'essentiel étant qu'il délivre un signal de sortie reflétant le module du champ.

**Revendications**

1. Dispositif de mesure des composantes d'un champ magnétique utilisant un magnétomètre scalaire (10, 14, 16, 21, 24, 26, 30, 40, 46, 56), ce magnétomètre délivrant un signal de sortie correspondant au module d'un champ magnétique appliqué, caractérisé en ce qu'il comprend en outre :

- au moins deux enroulements conducteurs (Ex, Ey, Ez) disposés autour dudit magnétomètre scalaire, ces enroulements conducteurs ayant des axes orientés dans des directions différentes (Ox, Oy, Oz),
- des moyens (Gx, Gy, Gz) pour alimenter chaque enroulement par un courant ayant une fréquence déterminée (Fx, Fy, Fz) propre à cet enroulement,
- des moyens de traitement (Dx, Dy, Dz) recevant le signal délivré par le magnétomètre scalaire, ces moyens étant aptes à effectuer des démodulations synchrones au moins aux fréquences (Fx, Fy, Fz) des courants d'alimentation des enroulements (Ex, Ey, Ez), ces moyens de traitement délivrant, pour chaque fréquence, un signal correspondant à la composante (Bx, By, Bz) du champ magnétique appliqué selon l'axe (Ox, Oy, Oz) de l'enroulement (Gx, Gy, Gz) alimenté à cette fréquence.

2. Dispositif selon la revendication 1, dans lequel les axes (Ox, Oy, Oz) des enroulements conducteurs (Ex, Ey, Ez) sont mutuellement orthogonaux.

3. Dispositif selon la revendication 1, dans lequel les moyens de traitement sont aptes en outre à effectuer des démodulations synchrones aux fréquences harmoniques ou à la combinaison linéaire des fréquences des courants d'alimentation des enroulements.

4. Dispositif selon la revendication 2, comprenant un premier enroulement conducteur (Ex) avec un premier axe (Ox) dirigé selon une première direction, un deuxième enroulement conducteur (Ey) avec un deuxième axe (Oy) dirigé selon une deuxième direction orthogonale à la première, les moyens de traitement (Dx, Dy) délivrant un premier signal correspondant à une première composante (Bx) du champ magnétique selon la première direction (Ox) et un deuxième signal correspondant à une deuxième composante (By) du champ magnétique selon la deuxième direction (Oy), les moyens étant en outre prévus pour calculer, à partir du signal délivré par le magnétomètre scalaire isotrope et correspondant au module (Bo) du champ magnétique appliqué et à partir desdits premier et deuxième signaux (Bx, By), un troisième signal correspondant à une troisième composante (Bz) du champ magnétique appliqué selon une troisième direction (Oz) orthogonale à la première (0x) et à la deuxième (Oy).

5. Dispositif selon la revendication 2, comprenant trois enroulements conducteurs (Ex, Ey, Ez) à axes mutuellement orthogonaux (Ox, Oy, Oz).

6. Dispositif selon la revendication 1, dans lequel le magnétomètre scalaire est un magnétomètre à pompage optique de l'hélium (14, 16, 21, 22, 24, 26, 30, 40, 46).

EP 0 964 260 A1

**Office européen des brevets**

# RAPPORT DE RECHERCHE EUROPEENNE

Numéro de la demande

EP 99 40 1366

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | EP 0 616 228 A (COMMISSARIAT ENERGIE ATOMIQUE) 21 septembre 1994 (1994-09-21) * page 4, ligne 44 – page 5, ligne 31 * | 1-5 | G01R33/26 |
| A | US 4 814 707 A (MARTON BELA I) 21 mars 1989 (1989-03-21) * colonne 1, ligne 28 – colonne 3, ligne 64 * | 1-6 | |
| A | EP 0 462 001 A (COMMISSARIAT ENERGIE ATOMIQUE) 18 décembre 1991 (1991-12-18) * colonne 4, ligne 32 – colonne 6, ligne 50 * | 1-6 | |

| | |
|---|---|
| | DOMAINES TECHNIQUES RECHERCHES (Int.Cl.6) |
| | G01R |

Le présent rapport a été établi pour toutes les revendications

| Lieu de la recherche | Date d'achèvement de la recherche | Examinateur |
|---|---|---|
| LA HAYE | 3 septembre 1999 | Diot, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03 82 (P04C02)

**ANNEXE AU RAPPORT DE RECHERCHE EUROPEENNE**
**RELATIF A LA DEMANDE DE BREVET EUROPEEN NO.**                    EP 99 40 1366

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

03-09-1999

| Document brevet cité au rapport de recherche | | Date de publication | Membre(s) de la famille de brevet(s) | | Date de publication |
|---|---|---|---|---|---|
| EP 0616228 | A | 21-09-1994 | FR | 2702845 A | 23-09-1994 |
| | | | CA | 2117160 A | 17-09-1994 |
| | | | US | 5404103 A | 04-04-1995 |
| US 4814707 | A | 21-03-1989 | JP | 1092676 A | 11-04-1989 |
| | | | JP | 2599762 B | 16-04-1997 |
| EP 0462001 | A | 18-12-1991 | FR | 2663431 A | 20-12-1991 |
| | | | CA | 2044531 A | 15-12-1991 |
| | | | DE | 69100784 D | 27-01-1994 |
| | | | DE | 69100784 T | 09-06-1994 |
| | | | US | 5245280 A | 14-09-1993 |

EPO FORM P0460

Pour tout renseignement concernant cette annexe : voir Journal Officiel de l'Office européen des brevets, No.12/82